(19) **Europäisches Patentamt / European Patent Office / Office européen des brevets**

(11) **EP 1 930 953 A1**

(12) **EUROPEAN PATENT APPLICATION**
published in accordance with Art. 153(4) EPC

(43) Date of publication:
**11.06.2008 Bulletin 2008/24**

(21) Application number: **06810271.4**

(22) Date of filing: **19.09.2006**

(51) Int Cl.:
*H01L 31/042* (2006.01)  *B32B 27/36* (2006.01)

(86) International application number:
**PCT/JP2006/318529**

(87) International publication number:
**WO 2007/040039 (12.04.2007 Gazette 2007/15)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **30.09.2005 JP 2005286336**

(71) Applicant: **TORAY INDUSTRIES, INC.**
**Tokyo 103-8666 (JP)**

(72) Inventors:
• **MIYAJI, Shinichiro**
 **Kouka-shi, Shiga 5280066 (JP)**
• **NOGUCHI, Masakazu**
 **Ikeda-shi. Osaka 5630024 (JP)**
• **KAWAJI, Naoki**
 **Ogaki-shi, Gifu 5030877 (JP)**

(74) Representative: **Kador & Partner**
 **Corneliusstrasse 15**
 **80469 München (DE)**

(54) **ENCAPSULATION FILM FOR PHOTOVOLTAIC MODULE AND PHOTOVOLTAIC MODULE**

(57)     An encapsulation film and photovoltaic module using the same are provided, being excellent in long-term reliability and wherein the degradation of gas-barrier property over long-term use (a problem in the conventional art) is curtailed. The film has as a base material an inexpensive polyester film that is excellent in mechanical characteristics and processability. Furthermore, the encapsulation film and photovoltaic module using the same are hydrolysis-resistant, transparent, weather-resistant, and lightweight. The encapsulation film comprises: a polyester film having a thermal shrinkage ratio of ($\pm$ 2) % at 150 °C in both the length-wise and width-wise directions, and additionally, wherein the difference between the thermal shrinkage ratios in the length-wise and width-wise directions at 150 °C is 2 % or less; and a layer composed of at least one member selected from the group consisting of metals, metal oxides, and inorganic compounds. The photovoltaic module uses the encapsulation film as a front sheet layer and/or a back sheet layer thereof.

**F i g .  4**

EP 1 930 953 A1

**Description**

TECHNICAL FIELD

The present invention relates to an encapsulation film for a photovoltaic module and a photovoltaic module using the encapsulation film.

More particularly, the invention relates to an encapsulation film for a photovoltaic module and a photovoltaic module using this encapsulation film, the film having excellent reliability in features such as durability of gas-barrier property and hydrolysis resistance, and additionally being exceptionally transparent, lightweight, and strong.

BACKGROUND ART

In recent years, photovoltaic cells developed as a next-generation energy source have spread rapidly, and are being deployed for home and industrial use.

The construction of a photovoltaic module typically involves assembling a plurality of photovoltaic elements, providing an encapsulation film on both sides of these photovoltaic elements via an adhesive resin filler, and then storing and encapsulating the photovoltaic elements within the encapsulation film. (Typically, the encapsulation film provided on the sunlight-incident side [the front surface] is called the "front sheet", and the encapsulation film provided on the non-sunlight-incident side [the back surface] is called the "back sheet").

In addition, there is a demand for photovoltaic modules having longer lifetimes wherein output does not lower for 20 to 30 years.

In order to achieve these longer lifetimes, it is important to block water and oxygen, which negatively affect the photovoltaic elements, and to prevent deterioration of the encapsulation film for the photovoltaic module (may be hereinafter referred to as encapsulation film), which occurs due to hydrolysis and ultraviolet rays. Moreover, demand for lowered prices is also strong, and efforts are being made to incorporate sunlight-reflecting functions into the encapsulation film while still lowering the costs of the encapsulation film.

Furthermore, a great deal of efforts are being made to improve electric conversion efficiency (i.e., the rate at which light is converted into electricity) by making the encapsulation film layer highly transparent, thus raising the ratio of incident sunlight.

The following films are known as conventional encapsulation films for a photovoltaic module.

(1) An encapsulation film using a fluororesin sheet and/or polyethylene terephthalate film (may be hereinafter referred to as PET film) as a base material, provided with an aluminum foil several tens of micrometers thick as a gas barrier layer.

(2) An encapsulation film wherein a vapor-deposition layer of an inorganic compound is provided as a gas barrier layer on a resin film having light-reflecting properties (for example, refer to the patent literature [1]).

(3) An encapsulation film comprising a weather-resistant film such as a fluororesin sheet and a transparent vapor-deposition layer of an inorganic compound, the object being to improve the weather resistance of the film (for example, refer to the patent literature [2]).

(4) An encapsulation film consisting of a three-layer laminated structure: a hydrolysis-resistant PET film layer, a metal oxide adherend layer for imparting gas-barrier property, and a white resin film layer (for example, refer to the patent literature [3]).

(5) An encapsulation film consisting of PET film and a gas barrier layer, wherein hydrolysis-resistance, weather-resistance, and reflecting efficiency have been improved (for example, refer to the patent literature [4]).

(6) An encapsulation film emphasizing transparency and weather-resistance, having a laminated structure consisting of a weather-resistant film and a transparent vapor-deposition film (for example, refer to the patent literature [5]).

In addition, the use of biaxially-oriented polyethylene naphthalate film (may be hereinafter referred to as PEN-BO) as an encapsulation film for a photovoltaic module is also known (for example, refer to the patent literature [3, 5]).

In addition, the use of a polyimide-resin-containing, biaxially-oriented polyethylene terephthalate film (may be hereinafter referred to as PET-BO) for electric insulation, such as in a circuit board material, has also been proposed (for example, refer to the patent literature [6]).

In addition, a laminated film being excellent in weather-resistance and transparency has also been proposed, wherein benzotriazole monomer copolymer acrylic resin layers are laminated upon at least one surface of a thermoplastic resin film such as a PET-BO film (for example, refer to patent literature [7]).

However, the conventional encapsulation films have the following respective problems, and thus their deployment, particularly in the field of photovoltaic modules, has been limited.

In the film (1) above, the use of aluminum foil in the gas barrier layer yields excellent gas-barrier property, but there are problems with the insulating properties of the encapsulation film. Additionally, this film could not be deployed for applications wherein transparency is required. Furthermore, there were problems in making the film lightweight.

In the encapsulation film (2) above, the film has been improved to be lightweight and have insulating properties. However, there was the problem of long-term reliability, as when the encapsulation film is used for a long period of time, its gas-barrier property degrades, and thus the output of the photovoltaic module decreases.

In the encapsulation film (3) above, the film's weather-resistance and hydrolysis-resistance are excellent due to the use of a fluorine film as a base material, and fluctuation in gas-barrier property is also low. However, since the mechanical strength of the fluorine film is low, the mechanical strength of the photovoltaic module is weak, and it was possible for the photovoltaic elements to be broken.

The encapsulation films of (4) and (5) above use a PET film, which is excellent in hydrolysis-resistance. For this reason, although deterioration of the film due to hydrolysis can be prevented, long-term use reduces the gas-barrier property similarly to the film (2) above. Consequently, there was the problem that the output of the photovoltaic module readily decreases.

Since the encapsulation film (6) above also uses a fluorine film as a base material, the film's weather-resistance and hydrolysis-resistance are excellent, and degradation of gas-barrier property is also low. However, since the mechanical strength of the fluorine film is low, the mechanical strength of the photovoltaic module is weak, and it was possible for the photovoltaic elements to be broken. Furthermore, in the case where a PET film is also used, long-term use degrades the gas-barrier property similarly to the film (2) above. Consequently, there is a problem in the long-term reliability of the film, i.e., the output of the photovoltaic module decreases.

Patent literature 1: Japanese Patent Application Kokai Publication No. 2000-114564

Patent literature 2: Japanese Patent Application Kokai Publication No. 2000-138387

Patent literature 3: Japanese Patent Application Kokai Publication No. 2002-100788

Patent literature 4: Japanese Patent Application Kokai Publication No. 2002-26354

Patent literature 5: Japanese Patent Application Kokai Publication No. 2000-164907

Patent literature 6: Japanese Patent Application Kokai Publication No. 2001-244587

Patent literature 7: Japanese Patent Application Kokai Publication No. H9-48095

DISCLOSURE OF INVENTION

Consequently, it is an object of the present invention, being devised in the light of the foregoing problems, to provide an encapsulation film for a photovoltaic module and a photovoltaic module using such an encapsulation film, the film being excellent in long-term reliability, having as a base material a low-cost polyester film excellent in mechanical characteristics and processability, and wherein the problem of the conventional art, i.e., the degradation of gas-barrier property after long-term use, is curtailed.

Furthermore, it is an object to provide, as a preferable mode of the invention, an encapsulation film and a photovoltaic module using the encapsulation film, wherein the film is exceptionally hydrolysis-resistant, transparent, weather-resistant, and lightweight.

The inventors have controlled the thermal dimensional change rate of the polyester film that acts as the base material to be within a particular range. In addition, the inventors have balanced the thermal dimensional change characteristics in the length-wise and width-wise directions. In so doing, the inventors have discovered how to curtail the change in gas-barrier property over time, the principal issue of the present invention.

More specifically, the invention that achieves the foregoing objects, being an encapsulation film for a photovoltaic module, has the following configuration (1).

(1) An encapsulation film for a photovoltaic module, comprising: a polyester film layer that has a thermal shrinkage ratio in both the length-wise and width-wise directions of $(0 \pm 2)$ % at 150 °C, and additionally wherein the difference between the thermal shrinkage ratios in the length-wise and widthwise directions is 2 % or less at 150 °C; and a layer comprising at least one substance selected from the group consisting of metals, metal oxides, and inorganic compounds.

Furthermore, this encapsulation film for a photovoltaic module in accordance with the present invention may comprise any of the following more concretely preferable configurations (2)-(10).

(2) The encapsulation film for a photovoltaic module according to (1), wherein the polyester film layer comprises a biaxially-oriented polyethylene terephthalate film having an intrinsic viscosity $[\eta]$ in the range 0.6 to 1.2.

(3) The encapsulation film for a photovoltaic module according to (1), wherein the polyester film layer comprises a polyimide-resin-containing, biaxially-oriented polyethylene terephthalate film.

(4) The encapsulation film for a photovoltaic module according to (1), wherein the polyester film layer comprises a biaxially-oriented polyethylene naphthalate film.

(5) The encapsulation film for a photovoltaic module according to any of the above (1)-(4), wherein the layer comprising at least one substance selected from the group consisting of metals, metal oxides, and inorganic compounds brings about gas-barrier property in the encapsulation film for a photovoltaic module, and wherein the encapsulation film as a whole has gas-barrier property such that its water vapor permeability is 2.0 g/m$^2$/24 hr/0.1 mm or less.

(6) The encapsulation film for a photovoltaic module according to any of the above (1)-(5), wherein the layer comprising at least one substance selected from the group consisting of metals, metal oxides, and inorganic compounds brings about gas-barrier property in the encapsulation film for a photovoltaic module, and wherein the encapsulation film as a whole has gas-barrier property such that its water vapor permeability, after aging, is less than 5.0 g/m$^2$/24 hr/0.1 mm.

(7) The encapsulation film for a photovoltaic module according to any of the above (1)-(6), wherein the total visible light transmittance is 80 % or greater.

(8) The encapsulation film for a photovoltaic module according to any of the above (1)-(7), wherein a resin layer having weather-resistant properties is laminated upon at least one surface of the encapsulation film for a photovoltaic module.

(9) The encapsulation film for a photovoltaic module according to (8), wherein the resin layer having weather-resistant properties comprises at least one or more sheets from among the group consisting of a fluororesin sheet, a polycarbonate resin sheet, and an acrylic resin sheet.

(10) The encapsulation film for a photovoltaic module according to (9), wherein the acrylic resin is a benzotriazole monomer copolymerized acrylic resin.

In addition, the photovoltaic module of the present invention that achieves the above-described objects may also comprise the following configurations (11) or (12).

(11) A photovoltaic module having, on at least one surface thereof, the encapsulation film for a photovoltaic module according to any of the above (1)-(10).

(12) A photovoltaic module having, on one surface thereof, the encapsulation film for a photovoltaic module according to any of the above (1)-(7), and also having, on another surface thereof, the encapsulation film for a photovoltaic module according to any of the above (8)-(10).

As a result of the foregoing encapsulation film for a photovoltaic module of the present invention, an encapsulation film for a photovoltaic module excellent in long-term reliability can be acquired at a relatively low cost, the film using a polyester film (which is excellent in mechanical strength and processability) as a base material, and wherein the degradation of gas-barrier property over long-term use (which has been a problem in the conventional art) is curtailed.

In addition, as a result of the encapsulation film for a photovoltaic module according to a preferable embodiment of the present invention, an encapsulation film for a photovoltaic module that is hydrolysis-resistant, weather-resistant, transparent, lightweight, and mechanically strong can be acquired.

The photovoltaic module using the encapsulation film for a photovoltaic module of the present invention is less subject to output reduction due to water vapor permeability.

Furthermore, a preferable embodiment of the photovoltaic module using the encapsulation film for a photovoltaic module of the present invention is strong against deterioration due to hydrolysis or ultraviolet rays, and also exhibits excellent characteristics with regard to transparency, lightness of weight, and mechanical strength. Consequently, the encapsulation film for a photovoltaic module of the present invention is ideal for reflective, daylighting (wherein transparency is necessary), and see-through photovoltaic modules.

BRIEF DESCRIPTION OF DRAWINGS

[Fig. 1] Fig. 1 shows the basic configuration of a photovoltaic module of the present invention.
[Fig. 2] Fig. 2 shows the basic configuration of an encapsulation film A for a photovoltaic module of the present invention.
[Fig. 3] Fig. 3 shows the basic configuration of an encapsulation film B for a photovoltaic module of the present invention.
[Fig. 4] Fig. 4 shows a configuration of a photovoltaic module of the present invention wherein the encapsulation film B is used for the front sheet layer, and the encapsulation film A is used for the back sheet layer.

Reference Numbers

**[0047]**

1: Front sheet layer
2: Adhesive resin filler layer
3: Photovoltaic element
4: Back sheet layer
5: Weather-resistant resin sheet layer
41: Membrane layer of metal or other materials

BEST MODE FOR CARRYING OUT THE INVENTION

The encapsulation film for a photovoltaic module of the present invention comprises at least: a polyester film layer that has a thermal shrinkage ratio in both the length-wise and width-wise directions within (0 ± 2) % at 150 °C, and additionally wherein the difference between the thermal shrinkage ratios in the length-wise and width-wise directions is 2 % or less at 150 °C; and a layer comprising at least one substance selected from the group consisting of metals, metal oxides, and inorganic compounds.

In the present invention, the polyester film may be a polyester polymer primarily composed of an aromatic dicarboxylic acid, an alicyclic dicarboxylic acid, or an aliphatic dicarboxylic acid plus a diol, that is then formed into a film. In particular, biaxially-oriented film that has been biaxially oriented and heat-treated is preferable.

The polyester polymer herein is not particularly limited, but the following are particularly preferable for their heat-resistance, hydrolysis-resistance, weather-resistance, and mechanical strength and the like: biaxially-oriented polyethylene terephthalate film having an intrinsic viscosity [η] in the range 0.60 to 1.20 (more preferably, 0.63 to 1.00), wherein terephthalic acid is used as the dicarboxylic acid component and ethylene glycol is used as the diol component (may be hereinafter referred to as PET-BO); and biaxially-oriented polyethylene-2,6-naphthalate film, wherein 2,6-naphthalene dicarboxylic acid is used as the dicarboxylic acid component and ethylene glycol is used as the diol component (may be hereinafter referred to as PEN-BO). The intrinsic viscosity [η] herein is the value measured at 25 °C after dissolving the polyester film in o-chlorophenol as a solvent, this viscosity being proportional to the degree of polymerization of the polyester polymer. When this intrinsic viscosity is less than 0.6, imparting hydrolysis-resistance and heat-resistance is difficult, and since this tends to degrade the hydrolysis-resistance of the encapsulation film, such values are not preferable. On the other hand, if this value exceeds 1.2, the melt viscosity increases and thus melt extrusion molding becomes difficult. Since this has a tendency to degrade the film-forming properties, such values are not preferable.

In addition, a biaxially-oriented, polyimide-containing polyester polymer film is preferable as the polyester film used in the present invention due to its heat-resistance, hydrolysis-resistance, weather-resistance, and mechanical characteristics. This polyimide, being polymer having melt moldability containing a cyclic imide group, is not particularly limited, so long as the advantages of the invention are not impaired. However, a polyetherimide containing a repeating unit made up of an aliphatic, alicyclic, or aromatic ether unit and a cyclic imide group is more preferable. In addition, the principal chain of the polyimide may also contain constituent units other than cyclic imide or ether units (for example, aromatic, aliphatic, or alicyclic ester units, oxycarbonyl units, etc.), so long as the advantages of the invention are not impaired thereby. Herein, the polyimide content is preferably 1 % to 50 % by mass, and more preferably 3 % to 30 % by mass, in consideration of the properties of heat-resistance, hydrolysis-resistance, weather-resistance, thermal dimensional stability, and the processability of the film.

If the quantity of components other than the above-described primary component polymer contained in the polyester film in accordance with the present invention is less than 50 % by mass, then additives, lubricants, colorants, or other polymers may also be added. In particular, if the reflection of light is an object, it is preferable to whiten the film by adding a suitable quantity of a substance such as titanium oxide or barium sulfate. Alternatively, if designability is an object, it is preferable to introduce additives for various colors, such as black, or colorants. In addition, the polyester film of the present invention also includes films whose dielectric constant has been reduced or whose partial discharge voltage has been increased by introducing minute air bubbles as a result of additives and drawing.

It is preferable for the encapsulation film for a photovoltaic module of the present invention to have total visible light transmittance of 80 % or greater, and more preferably 85 % or greater. In order to control the encapsulation film for a photovoltaic module of the present invention such that its total visible light transmittance is 80 % or greater, it is preferable to keep the additive quantity of the above-described additives to less than 5 % by mass.

Since the total visible light transmittance of less than 80 % tends to reduce the ratio of sunlight converted into electricity (may be hereinafter referred to as the electric conversion efficiency), such values are not preferable. Visible light herein refers to electromagnetic waves perceived by the human eye. These are waves having wavelengths in the approximate range of 350 nm to 800 nm, and are the most important light rays with respect to the electric conversion efficiency of a photovoltaic module. Moreover, the "total visible light transmittance" in the present invention is the transmittance of light having a wavelength of 550 nm, the value thereof being measured based on JIS K7105-1981.

In addition, the polyester film in accordance with the present invention may also be configured as a lamination of two or more layers of similar or different polymer layers. It is also preferable for ultraviolet absorbers, hydrolysis inhibitors, etc., to be coated or laminated on the film, or alternatively introduced as additives into the film.

In the present invention, it is important for the thermal shrinkage ratio in both the length-wise and width-wise directions of the above-described polyester film to be in the range of (0 ± 2) % at 150 °C, more preferably in the range of (0 ± 1.7) %, and even more preferably in the range of (0 ± 1.5) %. Additionally, it is important to use a polyester film wherein the difference between the length-wise and width-wise thermal shrinkage ratios at 150 °C is 2 % or less, and preferably 1.5 % or less.

This percentage difference between the length-wise and width-wise thermal shrinkage ratios at 150 °C herein is the value found by evaluating for the difference between the length-wise and width-wise thermal shrinkage ratios (%) at 150°C, and then taking the absolute value thereof.

In other words, by using a polyester film whose thermal shrinkage has been minimized as much as possible, and in addition whose length-wise and width-wise thermal shrinkage ratios have been balanced as much as possible, the degradation of gas-barrier property after long-term use in an encapsulation film for a photovoltaic module is curtailed (the object of the present invention). Thus, the reduction in output over time of a photovoltaic module can be improved.

The thermal shrinkage ratio herein refers to the value obtained by performing shrinkage processing on a film for 30 min at 150 °C and taking measurements based on JIS C2151-1990. The shrinkage direction is expressed as a positive value, while the expansion direction is expressed as a negative value.

If the value of the thermal shrinkage ratio in either the length-wise direction or the width-wise direction falls outside the range of (0 ± 2) %, the degradation of gas barrier performance becomes worse and the reduction in output over time of the photovoltaic module falls outside the allowable range. Thus it becomes difficult to acquire the advantages of the invention as expected. The reason for this is the configuration of one of the layers of the encapsulation film for a photovoltaic module of the present invention; specifically, the "layer comprising at least one substance selected from the group consisting of metals, metal oxides, and inorganic compounds" (may be hereinafter referred to as the "membrane layer of metal or other materials"). Although this layer brings about excellent gas barrier performance in the encapsulation film, if the value of the thermal shrinkage ratio at 150 °C in either the length-wise direction or the width-wise direction of the above polyester film falls outside the range of (0 ± 2) %, then the polyester film residing between the membrane layer of metal or other materials and the adhesive resin filler layer (wherein the photovoltaic element is filled and fixed) will undergo large, repeated dimensional changes, shrinking and expanding due to temperature changes in the installation environment. This subjects the membrane layer of metal or other materials (which brings about gas barrier performance for the entire encapsulation film) to large, repeated stresses. It is thought that as a result, cracking or flaking occurs in the membrane layer of metal or other materials, thus degrading water vapor barrier properties.

Furthermore, if a polyester film is used wherein the difference in thermal shrinkage ratios in the length-wise and width-wise directions exceeds 2 %, a similar problem occurs, and thus it becomes no longer possible to acquire the expected advantages of the invention. Consequently, simultaneously satisfying these two requirements is an important requirement for the present invention.

The above-described gas barrier performance of the encapsulation film for a photovoltaic module of the present invention is realized by the above-described membrane layer of metal or other materials. This membrane layer of metal or other materials is a layer with the performance to block gases such as water vapor and oxygen gas, and may be formed for example from metals, metal oxides, or inorganic substances such as silica in laminated layers of a single substance or two or more substances. The formation of the membrane layer itself is achieved using well-known techniques such as the vapor-deposition method or the spattering method. Aluminum oxides and silicon oxides are suitable as components forming this membrane layer.

The encapsulation film for a photovoltaic module of the present invention preferably attains gas-barrier property as a result of the above membrane layer of metal or other materials that, when expressed numerically, yields a water vapor permeability of 2.0 $g/m^2/24$ hr/0.1 mm or less over the whole of the encapsulation film for a photovoltaic module. In other words, if the membrane layer of metal or other materials were to be removed from the encapsulation film for a photovoltaic module of the present invention, the value of the water vapor permeability would become larger than the above value by several times or several tens of times, and the encapsulation film would no longer perform its function. According to a variety of findings by the inventors, ordinary polyester film wherein a membrane layer of metal or other materials is not provided typically has a water vapor permeability of approximately 7.2 $g/m^2/24$ hr/0.1 mm.

Also, the value of the water vapor permeability for the above-described encapsulation film for a photovoltaic module is the value measured before conducting a forced aging process; that is, it is a value expressing initial performance. However, this performance (i.e., a high water vapor permeability) is maintained even after subjecting the encapsulation film for a photovolatic module of the present invention to a particular aging process, to be hereinafter described.

This mechanism is brought about as a result of using the specific polyester film described in the foregoing.

In terms of specific performance, the encapsulation film for a photovoltaic module of the present invention preferably has, after being subjected to the aging process to be hereinafter described, a water vapor permeability of less than 5.0 $g/m^2/24$ hr/0.1 mm, i.e., the film has excellent post-aging gas barrier performance.

The gas barrier performance of the encapsulation film for a photovoltaic module in accordance with the present invention are the properties corresponding to performances such as oxygen transmission and water vapor transmission. However, the most important among these are the water vapor barrier performance. In particular, the encapsulation film for a photovoltaic module of the present invention is ideally assessed due to the water vapor transmission performance. The above-described water vapor permeability are the initial (pre-aging) and post-aging values of the water vapor permeability as measured using an identical method based on JIS Z0208-1973. Since both the initial performance level and the change in the performance level over time can thus be known, assessment of the film using these values is ideal.

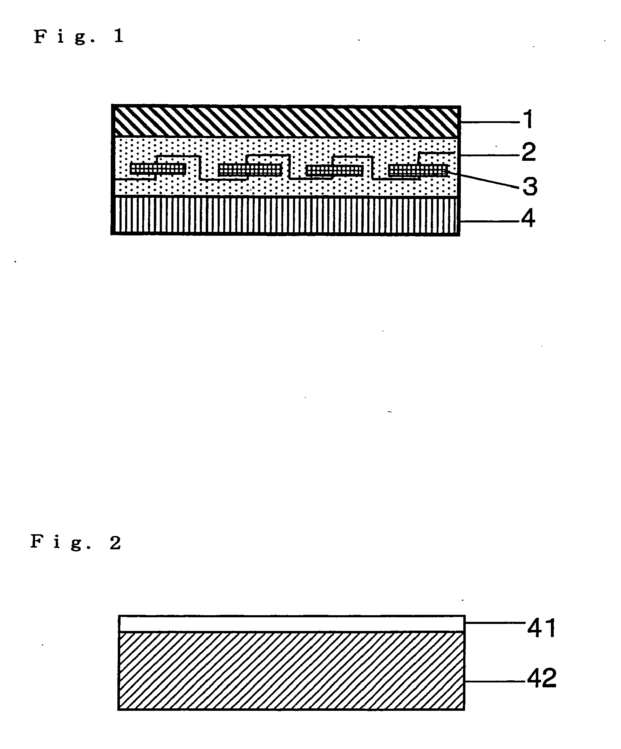

In the present invention, a photovoltaic module refers to a system that converts sunlight into electricity. An exemplary configuration of this module is shown in Fig. 1.

More specifically, Fig. 1 is a schematic cross-section showing an example of the basic configuration of the photovoltaic module of the present invention. A front sheet layer 1, comprising the encapsulation film for a photovoltaic module of the present invention, exists on the sunlight-incident side (front surface) of the module. 2 is an adhesive resin filler layer, and 3 are photovoltaic elements. A back sheet layer 4, consisting of the encapsulation film for a photovoltaic module of the present invention, exists on the non-sunlight-incident side (back surface) of the module.

In this way, the basic configuration comprises, from the sunlight-incident side, the front sheet layer 1, the adhesive resin filler layer 2 (front side), photovoltaic elements 3, the adhesive resin filler layer 2 (back side), and the back sheet layer 4. A photovoltaic module such as this may be built into and used on the roof of a residential home, or alternatively, installed on a building or fence, or used with electronic parts.

In addition, this photovoltaic module may also transmit light (referred to as daylighting-type and see-through-type modules) and thus be used in a window or in the soundproofing walls of highways, trains, etc. In addition, flexible-type modules are also being put to practical use.

The front sheet layer 1 herein is a layer provided in order to allow sunlight to pass efficiently therethrough, and in addition, to protect the photovoltaic elements inside the module. The adhesive resin filler layers are provided in order to provide adhesion and filler so as to store and seal the photovoltaic elements between the front sheet and the back sheet. Thus, properties such as weather-resistance, water-resistance (hydrolysis-resistance), transparency, and adhesiveness are required. As examples of suitable adhesive resin filler layers, ethylene vinyl acetate copolymer resin (may be hereinafter referred to as EVA), polyvinyl butyral, partially-oxidized ethylene vinyl acetates, silicon resins, ester resins, and olefin resins may be used; however, EVA is the most typical. In addition, since the back sheet layer is used in order to protect the photovoltaic modules on the back surface of the photovoltaic module, properties such as water vapor blocking properties, insulating properties, and in particular, excellent mechanical characteristics are required. Furthermore, although there are other types of back sheet layers, such as white-color types wherein sunlight incident on the front sheet side is reflected and re-used, types wherein a color such as black is applied to the back sheet layer for designability reasons, or transparent types wherein sunlight can be incident from the back sheet side as well, the present invention can be used with respect to all of these types. Herein, a transparent-type back sheet layer is one having a total light transmittance of preferably 80 % or greater, and more preferably 85 % or greater. The amount of incident sunlight is thus large, and thus such a transparent-type back sheet layer is preferable for implementation in an daylighting-type or see-through-type photovoltaic module.

In addition, as described above, the encapsulation film for a photovoltaic module of the present invention herein refers to the film comprising the front sheet layer 1 and the back sheet layer 4 in the basic configuration of a photovoltaic module shown in Fig. 1. As shown in Fig. 2, the basic laminated structure of this film comprises a membrane layer of metal or other materials 41 laminated to a polyester film layer 42 as described above. In addition, the membrane layer of metal or other materials 41 may be laminated on both sides of the module, or laminated in a plurality of layers in the direction of thickness.

The thickness of the encapsulation film for a photovoltaic module of the present invention is preferably in the range of 40 $\mu$m to 500 $\mu$m, and more preferably in the range of 50 $\mu$m to 300 $\mu$m. Films having thicknesses in this range are excellent for their mechanical strength, insulating properties, and processability. In addition, the thickness of the polyester film 42 used in the present invention is preferably in the range of 30 $\mu$m to 400 $\mu$m, and more preferably in the range of 35 $\mu$m to 250 $\mu$m.

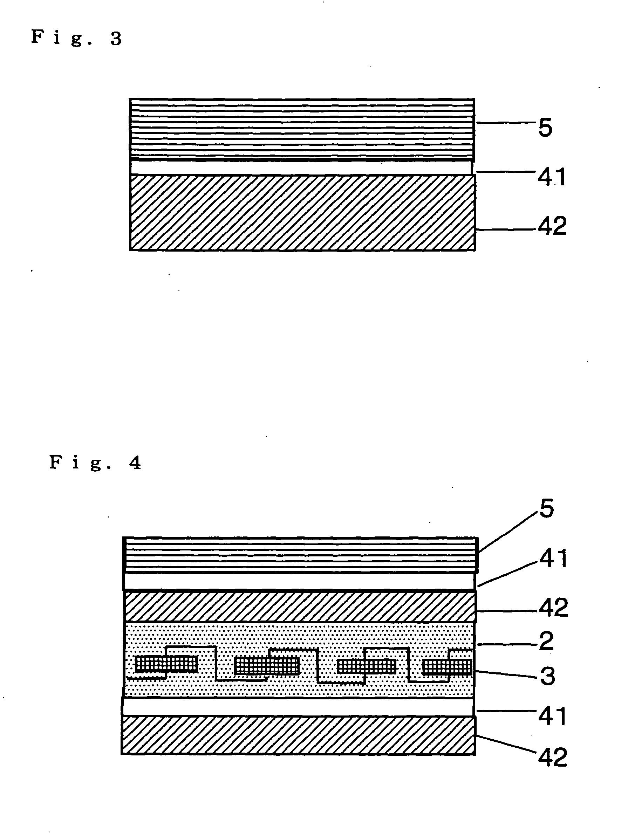

In addition, it is preferable that the encapsulation film for a photovoltaic module of the present invention includes a resin layer 5 having weather-resistance (may be hereinafter referred to as the weather-resistant resin layer) laminated onto at least one side of the laminated structure (at least sunlight-incident side) shown in Fig. 2, as shown in Fig. 3, for example. Such a structure is preferable because this resin layer 5 imparts weather-resistance to the entire photovoltaic module. In particular, the use of such a layer on the front sheet side is preferable.

Herein, "having weather-resistance" refers to the properties of a substance that is resistant to deterioration with respect to exposure to ultraviolet rays. Substances composed of fluororesin sheets, polycarbonate resins, or acrylic resins are particularly preferable as the resin layer having weather-resistance, due to their weather-resistance and their transparency. In consideration of transparency, processability, economic factors, and making the film lightweight, the thickness of the resin layer having weather-resistance is preferably in the range of 0.1 $\mu$m to 100 $\mu$m, and more preferably in the range of 5 $\mu$m to 100 $\mu$m.

Hereinafter, an encapsulation film of the present invention having a structure wherein a weather-resistant resin layer is not laminated thereto will be referred to as "encapsulation film A". In addition, an encapsulation film of the present invention having a structure wherein a weather-resistant resin layer is laminated thereto will be referred to as "encapsulation film B".

Herein, substances that may be used as a fluororesin sheet that can realize the resin layer having weather-resistance usable in the present invention include substances composed of the following: polytetrafluoroethylene (PTFE), perfluoroalkoxy resin (PFA) composed of a copolymer of tetrafluoroethylene and perfluoroalkyl vinyl ether, a copolymer of tetrafluoroethylene and hexafluoropropylene (FEP), a copolymer of tetrafluoroethylene, perfluoroalkyl vinyal ether, and hexafluoropropylene (EPE), a copolymer of tetrafluoroethylene and ethylene or propylene (ETFE), Polychlorotrifluoroethylene resin (PCTFE), a copolymer of ethylene and chlorotrifluoroethylene resin (ECTFE), polyvinylidene fluoride resin (PVDF), and polyvinyl fluoride (PVF), etc. In addition, polycarbonate or acrylic resin sheets may also include derivatives or modifications thereof.

In addition, in the present invention, the use of a benzotriazole monomer copolymerized acrylic resin for the acrylic resin is particularly preferable in consideration of its weather-resistance, transparency, and performance to form a thin membrane. Herein, a benzotriazole monomer copolymerized acrylic resin refers to a resin obtained by copolymerizing a benzotriazole reactive monomer and an acrylic monomer. Any variations thereof, such as organically soluble variations or water dispersible variations, may also be used. The monomer to be used as the benzotriazole monomer is not particularly limited, and may be any monomer having both benzotriazole in its basic skeleton and unsaturated double bonds. 2-(2'-hydroxy-5'-methacryloxyethylphenyl)-2H-benzotriazole is a preferable monomer in this case. For the acrylic monomer to be copolymerized with this benzotriazole monomer, an alkyl acrylate or alkyl methacrylate (the alkyl group being a methyl group, an ethyl group, an n-propyl group, an isopropyl group, an n-butyl group, an isobutyl group, a t-butyl group, a 2-ethylhexyl group, a lauryl group, a stearyl group, a cyclohexyl group, etc.), as well as a monomer having a crosslinkable functional group (for example, monomers having a carboxyl group, a methylol group, an acid anhydride group, a sulfonic acid group, an amide group or a methylolized amide group or amino group (including substituted amino groups), an alkyrolized amino group, a hydroxyl group, an epoxy group, etc.) may be used, for example. Examples of the above monomer having a functional group include: acrylic acid, methacrylic acid, itaconic acid, maleic acid, fumaric acid, crotonic acid, vinyl sulfonic acid, styrenesulfonic acid, acrylamide, methacrylamide, N-methyl methacrylamide, methylolized acrylamide, methylolized methacrylamide, diethylamino ethyl vinyl ether, 2-amino ethyl vinyl ether, 3-amino propyl vinyl ether, 2-amino butyl vinyl ether, dimethylamino ethyl methacrylate and methylolizations of the foregoing amino groups, $\beta$-hydroxyethyl acrylate, $\beta$-hydroxyethyl methacrylate, $\beta$-hydroxypropyl acrylate, $\beta$-hydroxypropyl methacrylate, $\beta$-hydroxyvinyl ether, 5-hydroxypentyl vinyl ether, 6-hydroxyhexyl vinyl ether, polyethylene glycol monoacrylate, polyethylene glycol monomethacrylate, glycidyl acrylate, and glycidyl methacrylate. However, the monomer is not necessarily limited to the above.

Furthermore, other than the above, the following may also be used as copolymer components: acrylonitrile, methacrylonitrile, styrene, butyl vinyl ether, maleic acid and itaconic acid monomers or dialkyl esters, methyl vinyl ketone, vinyl chloride, vinylidene chloride, vinyl acetate, vinyl pyridine, vinyl pyrrolidone, vinyl- group-containing alkoxysilane, and polyesters having unsaturated bonds, for example.

In the present invention, a single type of monomer or two or more types of monomers from among the above acrylic monomers may be copolymerized in an arbitrary ratio. Preferably, a copolymer whose acrylic component contains 50 mass% or more of methyl methacrylate or styrene, and more preferably, contains 70 mass% or more. Such values are preferable because they harden the weather-resistant resin layer.

Regarding the copolymer ratio of the benzotriazole monomer and the acrylic monomer, the proportion of the benzotriazole monomer is preferably 10 mass% to 70 mass% or less, more preferably 20 mass% to 65 mass% or less, and most preferably 25 mass% to 60 mass% or less. Such values are preferable in consideration of weather-resistance, the adhesive properties imparted to the weather-resistant resin layer of the encapsulation film A, and the durability of the weather-resistant resin layer. The molecular weight of this copolymer is not particularly limited, but is preferably 5000 or greater, and more preferably 10,000 or greater in consideration of the durability of the weather-resistant resin layer. In addition, the thickness of the weather-resistant resin layer is not particularly limited, but in consideration of weather-resistance and blocking prevention, a thickness in the range of 0.3 $\mu$m to 10 $\mu$m is particularly preferable.

In the encapsulation film B in accordance with the present invention, the above-described resin layer having weather-resistance may be laminated to both sides of the polyester film in accordance with the present invention, or alternatively, a plurality of resin layers may be applied in a multilayered structure. The total light transmittance of the encapsulation film B is preferably 80 % or greater, and more preferably 85 % or greater.

The encapsulation film for a photovoltaic module of the present invention may be used on at least one side of a photovoltaic module having the configuration shown in Fig. 1, but the invention also includes photovoltaic modules having a configuration wherein the encapsulation film B is provided in the direction of incident sunlight (the front sheet side), and the encapsulation film A is provided on the back sheet on the back side, as shown in Fig. 4. Photovoltaic modules having such a configuration are ideal in fields where high reliability and a lightweight module are particularly required. It should be appreciated that in the case of this configuration, a color such as white may be applied to the polyester film layer of the encapsulation film A or a transparent type may be suitably used according to the purpose of the application.

In addition, a circuit may also be formed on the front surface of the encapsulation film for a photovoltaic module of the present invention using a metal layer, an electrically conductive resin layer, a transparent conductive layer, or similar means.

Furthermore, the encapsulation film for a photovoltaic module of the present invention may also comprise a lamination of two or more combined layers that are identical to or different from the polyester film in accordance with the present invention. Applicable examples of combinations of laminar structures in this case include a [membrane layer of metal or other materials - PET-BO of the present invention - ordinary PET-BO] laminar structure, a [membrane layer of metal or other materials - PEN-BO of the present invention - ordinary PET-BO] laminar structure, a [membrane layer of metal or other materials - PET alloy film of the present invention] laminar structure, or a [membrane layer of metal or other materials - PEN-BO of the present invention - PET-BO of the present invention] laminar structure.

The thickness of the film layer directly joined to the membrane layer of metal or other materials (gas barrier layer) is preferably in the range 5 $\mu$m to 25 $\mu$m in consideration of the processing of the membrane layer of metal or other materials (gas barrier layer).

In addition, the membrane layer of metal or other materials (gas barrier layer) may also be laminated in any position along the direction of thickness of the encapsulation film layer for a photovolatic module of the present invention.

(A) Method of producing the encapsulation film for a photovoltaic module in accordance with the present invention

Hereinafter, the production method for the encapsulation film for a photovoltaic module of the present invention will be described taking the following (a)-(c) as examples.

(a) Polyethylene terephthalate film

Hereinafter, the description of the production method of a polyester film having the above-described thermal shrinkage characteristics in accordance with the present invention will be described taking polyethylene terephthalate film as an example.

The polymer polyethylene terephthalate (may be hereinafter referred to as PET) can be acquired from terephthalic acid (or a derivative thereof) and ethylene glycol using the conventionally known method of transesterification. During the transesterification, conventional reaction catalysts and discoloration-preventing agents can be used. The reaction catalyst may include: alkali metal compounds, alkaline earth metal compounds, zinc compounds, lead compounds, manganese compounds, cobalt compounds, aluminum compounds, antimony compounds, and titanium compounds. Phosphorus compounds may be used as the discoloration-preventing agent. It is preferable to introduce an antimony compound, a germanium compound, or a titanium compound as a polymerization catalyst at an arbitrary point before the completion of the PET production. Taking a germanium compound as an example, in this type of method powdered germanium compound may be added as-is, or the germanium compound may be added by dissolving it in the glycol component (PET base material) as described in Japanese patent Koukoku publication No.S54-22234.

For a method to control the intrinsic viscosity [$\eta$] of the polyester film having the above-described thermal shrinkage characteristics in accordance with the present invention to be within the range of 0.6 to 1.2, it is preferable to use the method known as the solid phase polymerization method, wherein a polymer obtained using the foregoing methods and having an [$\eta$] of 0.6 or less is heated to a temperature in the range of 190 °C to less than the PET melting point in vacuo or in an inert gas such as nitrogen gas. With this method, the intrinsic viscosity of the PET can be raised without increasing the number of carboxyl end groups.

A polymer obtained in this way is dried as necessary, and then fed into the conventionally known melt extruder and melted. Subsequently, a sheet is extruded from a slit-like die, adhesed to a metal drum, and then cooled to a temperature at or less than the polymer's glass transition temperature (may be hereinafter referred to as the Tg), thereby obtaining an unstretched film. By drawing the film using methods such as the simultaneous biaxial drawing method or the sequential biaxial drawing method, a biaxially-oriented film can be obtained.

The conditions in this case are as follows. The drawing temperature can be chosen between the Tg of the polymer and the Tg + 100 °C. Typically, a temperature in the range of 80 °C to 170 °C is preferable due to the physical properties and productivity of the ultimately obtained film. The draw ratio in both the length-wise and width-wise directions can be chosen from within the range of 1.6 to 5.0. From the perspective of low heat shrinkage of the obtained film, balancing the length-wise and width-wise directions, and maintaining a uniform film thickness, the draw ratio in both the length-wise and width-wise directions is preferably in the range of 2 to 4.5, with the orientation ratio of drawing (length-wise direction ratio versus width-wise direction ratio) in the range of 0.75 to 1.5. Also, a per-minute drawing speed in the range of 1000 % to 200000 % is preferable. Heat treatment is also performed, and the method thereof may involve conducting heat treatment continuously in a heat treatment chamber following a tenter whereupon width-wise direction is performed, heating the film in a separate oven, or heat-treating using a heating roll. For low heat shrinkage of the obtained film and balancing the thermal shrinkage ratios in the length-wise and width-wise directions, the tenter method is the most preferable among these methods, as it restrains (secures) the length-wise and width-wise directions and does not destroy the balance of the molecular orientations in the length-wise and width-wise directions. The heat treatment condition are preferably a temperature of 150 °C to 245 °C (more preferably 170 °C to 235 °C), a time of 1 s to 60 s, and relaxation conducted under a shrinkage limit in the width-wise direction that is preferably 12 % or less, and more preferably 10 % or less. Such conditions are preferable for low heat shrinkage and balancing (i.e., reducing the difference between) the thermal shrinkage ratios in the length-wise and width-wise directions.

The film whose molecular orientation has thus been balanced in the length-wise and width-wise directions is then furthermore subject to relaxation treatment (hereinafter, off-line annealing treatment). Off-line annealing treatment is particularly preferable for low heat shrinkage and balancing the thermal shrinkage ratios in the length-wise and width-wise directions. The off-line annealing treatment method may comprise conventionally known methods such as the hot blast oven method or the roll method. However, for lowering the thermal shrinkage ratio and flatness, the hot blast oven method is particularly preferable as it is thereby possible to conduct low-tension annealing treatment at a temperature of 120 °C to 200 °C for approximately 1 to 30 min.

In addition, for controlling the low heat shrinkage and the balancing of the thermal shrinkage ratios in the length-wise and width-wise directions, it is preferable to conduct a final thermal shrinkage ratio control with the off-line annealing treatment, wherein the thermal shrinkage ratios at 150 °C for the length-wise and width-wise directions are both controlled to be 2.5 % or less than the values during the membrane formation process, and wherein the difference between the thermal shrinkage ratios at 150 °C in the length-wise and width-wise directions is controlled to ($\pm$ 2) % or less.

In this way, a biaxially-oriented polyethylene terephthalate film (PET-BO) having the above-described thermal shrinkage characteristics is obtained.

(b) Polyethylene naphthalate film

Hereinafter, a production method of the polyester film in accordance with the present invention will be described taking polyethylene naphthalate film as an example.

Polyethylene naphthalate (may be hereinafter referred to as PEN) is typically produced using the conventionally known method wherein polycondensation is conducted on naphthalene-2,6-dicarboxylic acid (or a functional derivative thereof, such as naphthalene-2,6-dicarboxylic acid methyl) and ethylene glycol in the presence of a catalyst and under suitable reaction conditions. An intrinsic viscosity of 0.5 or greater corresponding to this polymer's degree of polymerization is preferable in consideration of mechanical characteristics, hydrolysis resistance, heat resistance, and weather resistance. The method to increase this intrinsic viscosity may comprise heat treatment or solid phase polymerization at the melting point temperature or less in vacuo or in an inert gas atmosphere.

In order to convert the PEN thus obtained into a biaxially-oriented film, first the polymer is dried, formed into a sheet using a melt extruder at a temperature in the range 280 °C to 320 °C, and then cast at a temperature equal to or less than the Tg, thereby obtaining a biaxially-oriented film using a similar method to that of the PET-BO described above. The drawing conditions in this case preferably comprise a draw ratio in the range of 2 to 10 for both the length-wise and width-wise directions at a temperature of 120 °C to 170 °C, and a orientation ratio of drawing (length-wise direction ratio versus width-wise direction ratio) in the range of 0.5 to 2.0. Such conditions are preferable for maintaining a uniform thickness and balancing the thermal shrinkage ratios in the length-wise and width-wise directions.

This film is then subject to heat treatment using the same method as that of the above-described PET-BO. The heat treatment conditions are preferably a temperature of 200 °C to 265 °C (more preferably 220 °C to 260 °C), a time of 1 s to 180 s, and relaxation in the width-wise direction under a shrinkage limit that is preferably 7 % or less. For low heat shrinkage of the obtained film and balancing the thermal shrinkage ratios in the length-wise and width-wise directions, it is particularly preferable for the film thusly obtained to be furthermore subject to off-line annealing treatment using a conventionally known method such as the hot blast oven method or the roll method. Off line annealing treatment conducted at a temperature of 120 °C to 220 °C for 0.5 min to 30 min. and using a low-tension annealing treatment process is effective.

In this way, a biaxially-oriented polyethylene naphthalate film (PEN-BO) having the above-described thermal shrinkage characteristics is obtained.

(c) Polyimide-resin-containing polyester film

Hereinafter, a production method for the polyester film in accordance with the present invention will be described taking polyimide-resin-containing polyester film as an example.

Polyimide-resin-containing polyester film is produced from polyetherimide resin and PET resin (may be hereinafter referred to as PET alloy). Polyetherimide resin can be obtained using the method described in the patent literature (6), for example. PET obtained as described above that has not yet been subject to solid phase polymerization is vacuum dried for 1 hr to 5 hr at a temperature of 150 °C to 180 °C. This PET resin is then mixed in a mixer with a quantity of polyetherimide resin that is preferably in the range of 1 mass% to 50 mass%, and more preferably 3 mass% to 30 mass%. Subsequently, this mixture is inserted into a melt extrusion machine (typically an extruder) and is melt-kneaded, preferably at a temperature of 280 °C to 340 °C, and more preferably 290 °C to 330 °C. Subsequently, the kneaded mixture is extruded underwater into gut shapes that are cut into segments of set length, thereby obtaining PET alloy base material.

To convert this base material into biaxially-oriented film, a method similar to that of the above PET-BO and PEN-BO may be used. In terms of concrete drawing conditions, a temperature in the range of the Tg to the Tg + 100 °C and a draw ratio of 1.5 to 7 in both the length-wise and width-wise directions is preferable, in consideration of the film's uniformity of thickness, mechanical characteristics, hydrolysis-resistance, heat-resistance, and low heat shrinkage. In addition, an orientation ratio of drawing (length-wise direction ratio versus width-wise direction ratio) in the range 0.5 to 2 is preferable in consideration of the balancing of the thermal shrinkage ratios in the length-wise and width-wise directions. Furthermore, heat treatment can also be conducted using a method similar to that of the PET-BO. The heat treatment conditions in this case preferably comprise a relaxation treatment at a temperature of 200 °C to 250 °C for a time of 1 s to 120 s with a shrinkage limit in the width-wise direction of 10 % or less. Furthermore, off-line annealing treatment may also be conducted using the hot blast oven method or the heat roll method. In this case, conducting annealing treatment using a hot blast oven at a temperature of 120 °C to 200 °C for a time of approximately 1 min to 30 min is preferable.

(B) Method for producing the encapsulation film for a photovoltaic module in accordance with the present invention

Hereinafter, the methods for producing the encapsulation film A and the encapsulation film B for a photovoltaic module of the present invention will be described.

(a) Encapsulation film A for a photovoltaic module

First, the encapsulation film A in accordance with the present invention will be described.

The membrane layer (gas barrier layer) of metal or other materials applied to the encapsulation film is applied to at least one surface of a polyester film in accordance with the present invention (PET-BO, PEN-BO, PET alloy film, etc.) that has been produced in advance. The membrane may comprise a simple substance or compound of metal oxides, such as aluminum oxide, silicon oxide, magnesium oxide, tin oxide, and titanium oxide. The membrane can be formed using the conventionally known methods of vacuum vapor deposition or the spattering method. During formation, metal oxide layers of the same or different types may also be formed in a plurality of laminated layers. The thickness in this case should typically be in the range of 100 Å to 2000 Å.

In addition, before creating the membrane layer (gas barrier layer) of metal or other materials, it is preferable to perform surface treatment on the surface of the polyester film in accordance with the present invention in order to ease adhesion. In addition, a method may also be used wherein the foregoing barrier layer is created on a separate film, and then this film is laminated via an adhesive agent to at least one surface of the polyester film in accordance with the present invention that has been produced in advance. The lamination method may comprise applying a coat of an adhesive solution such as a urethane, polyester, acrylic, or epoxy solution using a method such as the gravure roll coater, reverse coater, or die coater method, drying, and then laminating using the heat roll lamination method at a temperature of 50 °C to 120 °C. The separate film used in this case is preferably a polyester film having a thickness of 5 $\mu$m to 20 $\mu$m, for processability and economic reasons. Needless to say, a variety of pro-adhesive treatments may also be performed in order to improve adhesive properties.

Furthermore, if this separate film described above has a thickness of 25 $\mu$m or less, then ordinary PET-BO can be used, and moreover, a polyester film having a thickness of 5 $\mu$m to 25 $\mu$m and thermal shrinkage characteristics in accordance with the present invention can also be used. In other words, in this case, the polyester film having thermal shrinkage characteristics in accordance with the present invention has a structure wherein two or more layers of the film are laminated. This structure is particularly preferable as it is excellent for achieving the advantages of the invention.

In addition, the encapsulation film B in accordance with the present invention may be laminated as a weather-resistant film to at least one surface (at least one sunlight-incident surface) of the encapsulation film A produced as above; for example, a fluorine film may be laminated. A lamination method similar to the above-described may be used, wherein a membrane layer (gas barrier layer) of metal or other materials is provided on a separate film, and this separate film is then laminated to the polyester film in accordance with the present invention. In other words, a weather-resistant film may be laminated via an adhesive agent to at least one surface of the polyester film in accordance with the present invention. In this case, it is preferable for the adhesive agent to contain an ultraviolet absorber and be highly transparent. Usable adhesive agents include urethane, acrylic, epoxy, ester, and fluorine-based agents. In addition, the thickness of the adhesive layer is preferably in the range of 1 $\mu$m to 30 $\mu$m, in consideration of adhesive strength and transparency. It is also rather preferable to perform pro-adhesive treatment on fluorine-based films.

(b) Encapsulation film B for a photovoltaic module

Next, a method for producing the encapsulation film B using a benzotriazole monomer copolymerized acrylic resin in accordance with the present invention will be described.

This copolymer is not particularly limited, and may be obtained by conventionally known methods such as the radical polymerization method.

In the present invention, the above-described copolymer is laminated to a polyester film or the encapsulation film A as an organic solvent or a water dispersion. The thickness of this copolymer is preferably 0.3 $\mu$m to 10 $\mu$m, and more preferably 0.6 $\mu$m to 7 $\mu$m. When the thickness of the coat is thinner than 0.3 $\mu$m, the weather-resistant effects might be reduced. When the thickness of the coat is thicker than 10 μm, the surface of the film is smoothed due to the laminated membrane and blocking might occur more readily. Moreover, from an economic perspective there is no need to make the coat thicker than is necessary. In particular, a coat that satisfies the condition that the relationship between the surface roughness (Ra) and the laminar thickness (d) is in the range of 0.15 Ra < d < 1000 Ra for laminar thicknesses in the range of 0.3 μm to 10 μm is ideal.

In addition, in the present invention, it is preferable that microparticles or other materials are not added to the encapsulation film B, so as to improve the transparency of the encapsulation film B residing between the weather-resistant resin layers. However, organic and inorganic particles may be added to the film to the degree that transparency is not reduced. The microparticles that are added as necessary are not particularly limited, and organic or inorganic particles may be added. Inorganic particles may include calcium carbonate, silica, and alumina. Organic particles may include acrylic, polyester, and cross-linked acrylic particles. The weather-resistant layer may be provided according to conventionally known methods. For example, the weather-resistant resin layer may be provided upon a biaxially-oriented polyester film using an arbitrary method such as the roll coat method, the gravure coat method, the reverse coat method, or the rod coat method. Furthermore, the weather-resistant resin layer may be provided either before or after a membrane layer (gas barrier layer) of metal or other materials has been provided on the biaxially-oriented polyester film. In addition, a method may also be preferably used wherein the weather-resistant resin layer is applied, using any of the above methods, to the surface of the polyester film before the crystal orientation thereof is complete. The film is then dried, drawn in at least one direction, and then the crystal orientation thereof is completed.

Various surface treatments may also be performed on the polyester film in order to increase adhesiveness with the weather-resistant resin layer. In other words, an arbitrary treatment such as the following may be performed: corona discharge treatment in an atmosphere of air, nitrogen gas, or carbon dioxide; various anchor coat treatments using polyester resin, acrylic resin, urethane resin, vinyl chloride-acetate resin, etc.; flame treatment; and plasma treatment.

In addition, in the case where the light transmittance of the encapsulation film of the present invention is to be 80 % or greater, it is preferable for the PET-BO, PEN-BO, or PET alloy film used to have a light transmittance of 85 % or greater.

(C) Method for producing the photovolatic module in accordance with the present invention

Next, a method for producing the photovolatic module in accordance with the present invention will be described.

For example, consider a systemization using the configuration shown in Fig. 1, for example. A transparent glass sheet is prepared as the front sheet layer, and the encapsulation film A obtained as above is prepared as the back sheet layer. A module can then be constructed by laminating, on both sides of the photovoltaic elements 3, the above front sheet 1 and the encapsulation film A (preferably taking the membrane layer [gas barrier layer] of metal or other materials as the adhesing side), with adhesive resin filler layers 2 (EVA of thickness 100 μm to 1000 μm, for example) therebetween.

In addition, given that providing a lightweight module is an object of the present invention, the encapsulation film A or the encapsulation film B may also be used as the front sheet layer in the above configuration. However, in consideration of weather-resistance, a photovoltaic module wherein the encapsulation film B is used as the front sheet layer is preferable. In addition, in this case, the encapsulation film A may be a transparent-type film, or a color such as white may be applied thereto.

Various conventionally known methods may be used as the lamination method herein, but vacuum lamination is preferable since lamination can be conducted uniformly and with little risk of defects such as wrinkling and air bubbles. The lamination temperature should typically be in the range of 100 °C to 180 °C.

Furthermore, the photovoltaic module may also be constructed wherein a wire lead that can extract electricity is attached and secured by sheathing material.

Examples

Hereinafter, examples will be described and the invention will be described in further detail. First, evaluation methods will be described for the various characteristics of the encapsulation films for a photovoltaic module obtained in each of the following examples and comparative examples.

Physical properties, evaluation methods and standards

(1) Intrinsic viscosity [η]

Values measured in orthochlorophenol of concentration 0.1 q/ml at a temperature of 25 °C where used. The sample number n for each example/comparative example was taken to be 3, and the average value thereof was taken to be the intrinsic viscosity for each example/comparative example.

(2) Thermal shrinkage ratio

In conformance with JIS C2151-1990, thermal shrinkage was conducted at 150 °C for 30 min and evaluated by taking measurement lengths of 200 mm and using the following calculation method.
Samples were of length 250 mm and width 20 mm were prepared, wherein five samples had lengths of 250 mm along the length-wise direction of the film, and five samples had lengths of 250 mm along the width-wise direction of the film. On each sample, marker lines spaced 200 mm apart were applied, being centered on the center of the samples. The distance between these marker lines (the measurement length) was measured for each sample before and after heat treatment, the measurement taken to tenths of millimeters using a lens-attached metal ruler. Thermal shrinkage ratios were then calculated to three decimal places using the calculation method below (the fourth decimal place was rounded). The thermal shrinkage ratios (to three decimal places) were then averaged and truncated to two decimal places, thereby obtaining thermal shrinkage ratios of the five samples (to two decimal places) for each example/comparative example.
In Table 2, shrinkage is expressed as a positive value, and expansion is expressed as a negative value. MD refers to the length-wise direction of the film, and TD refers to the width-wise direction.

$$\text{Thermal shrinkage ratio} = (\text{measurement length at room temperature} -$$

$$\text{measurement length after heat treatment at 150 °C for 30 min})/$$

$$\text{measurement length at room temperature} \times 100 \, (\%)$$

(3) Balance of thermal shrinkage ratios ("Thermal ShrinkageBalance" in Table 2)

For each example/comparative example, the difference between the thermal shrinkage ratios (to two decimal places) in the length-wise and width-wise directions as measured using the method in (2) above was evaluated and expressed as an absolute value. These absolute values were taken as-is as a measure of the balance between the thermal shrinkage ratios.

(4) Total light transmittance

In conformance with JIS K7105-1981, encapsulation films were measured using light having a wavelength of 550 nm. The sample number n for each example/comparative example was taken to be 3, and the average value thereof was taken as the total light transmittance for each example/comparative example.

(5) Post-aging water vapor permeability

A 30 cm square section of encapsulation film was secured on four sides by being sandwiched between metal plates of thickness 2 mm. The film was then held under fixed tension by applying a weight of 1 kg on each of these four sides. Under these conditions, the film was aged for 2000 hr in an 85 °C, 93 %RH atmosphere. Water vapor permeability was measured before and after this aging, based on JIS Z0208-1973. Measurement condition was set as a temperature of 40 °C and a humidity of 90 %RH.
Initial water vapor permeability was controlled to be equal to or less than 0.5 g/m$^2$/24 hr/0.1 mm by using aluminum hydroxide as a gas barrier layer to form a membrane of thickness 600 Å by spattering. Having done so, the permeability was measured and evaluated after the above-described aging treatment. The sample number n for each example/comparative example was taken to be 3, and the average value thereof was taken to be the post-aging water vapor permeability for each embodiment/comparative example.
The basis for evaluation was taken to be the three grades below, wherein "A" denotes "Excellent", "B" denotes "Typical", and "C" denotes "Poor". Excellent (A): Water vapor permeability of less than 5 g/m$^2$/24 hr/0.1 mm. Typical (B): Water vapor permeability equal to or greater than 5 g/m$^2$/24 hr/0.1 mm, and less than 6.25 g/m$^2$/24 hr/0.1 mm.
Poor (C): Water vapor permeability equal to or greater than 6.25 g/m$^2$/24 hr/0.1 mm.

(6) Hydrolysis-resistance

A slit 10 mm in width (150 mm in length) was cut into an encapsulation film of size 80 mm x 200 mm in advance so as to allow measurement of tensile strength. This film was placed inside of a constant temperature, constant humidity tank, and aged for 2000 hr in an 85 °C, 93 %RH atmosphere. Breaking strength was measured before and after this aging, based on JIS C2151.

Comparative evaluation was then conducted using the ratio (the retention ratio), wherein the non-aged breaking strength is taken to be 100 %. The basis for evaluation was taken to be the three grades below, wherein "A" denotes "Excellent", "B" denotes "Typical", and "C" denotes "Poor".

Excellent (A): Retention ratio is equal to or greater than 30 %.

Typical (B): Retention ratio is equal to or greater than 24 %, and less than 30%.

Poor (C): Retention ratio is less than 24 %.

(7) Weather-resistance

Using the EYE Super UV Tester accelerated testing apparatus, the following cycle was conducted for five cycles, the retention ratio was evaluated using the tensile strength testing method in (6) above, and a comparative evaluation was conducted.

One cycle: Exposure to ultraviolet light for 8 hr in a 60 °C, 50 %RH atmosphere, followed by 4 hr aging under condensation conditions (35 °C, 100 %RH).

The basis for evaluation was taken to be the three grades below, wherein "A" denotes "Excellent", "B" denotes "Typical", and "C" denotes "Poor". Excellent (A): Retention ratio is 30 % or greater.

Typical (B): Retention ratio is equal to or greater than 24 %, and less than 30%.

Poor (C): Retention ratio is less than 24 %.

(8) Overall evaluation of encapsulation film (overall evaluation)

An overall evaluation of the encapsulation films, based on the test results from the above post-aging water vapor permeability test, hydrolysis-resistance test, and weather-resistance test is given by the three grades below, wherein "A" denotes "Excellent", "B" denotes "Typical", and "C" denotes "Poor".

Excellent (A): All tests resulted in "A".

Typical (B): All or a portion of the tests resulted in "B", and none of the tests resulted in "C".

Poor (C): All or a portion of the tests resulted in "C".

(9) Output evaluation of photovoltaic module

Photovoltaic modules were constructed using each of the encapsulation films fabricated in examples 1-10, example 21, and comparative examples 1-3. The following output evaluation was then respectively conducted on these photovoltaic modules designated as examples 11-20, example 22, and comparative examples 4-6.

Environmental tests based on JIS C8917-1998 were conducted on the photovoltaic modules. Photovoltaic output was measured before and after the tests and is expressed as the following output reduction ratio (%).

$$(\text{pre-test photovoltaic value} - \text{post-test photovoltaic value})/\text{pre-test}$$

$$\text{photovoltaic value} \times 100 \ (\%)$$

Evaluation results are taken to be two grades either "Acceptable" or "Unacceptable", wherein an output reduction equal to or less than 10 % is assessed to be an "Acceptable" result.

Example 1

(1) Fabrication of PET polymer

100 parts dimethyl terephthalate (hereinafter referred to as parts by mass) were mixed with 64 parts ethylene glycol. 0.06 parts magnesium acetate and 0.03 parts antimony trioxide were added as catalyst, and transesterification were conducted while heating from 150 °C to 235 °C.

To this mixture 0.02 parts trimethyl phosphate were added and gradually heated, and polymerization was conducted at a temperature of 285 °C in vacuo for 3 hr. The intrinsic viscosity [η] of the obtained polyethylene terephthalate (PET) was 0.57. This polymer was cut into chips of length 4 mm.

The PET having an intrinsic viscosity [η] of 0.57 obtained as above was placed into a heating vacuum apparatus (a rotary dryer) having a condition of temperature of 220 °C and a vacuum degree of 0.5 mmHg, and heated while mixing for 20 hr. The intrinsic viscosity of the PET obtained in this way was 0.75. This polymer is taken to be PET-1.

(2) Fabrication of biaxially-oriented PET film (PET-BO)

PET-1 and a master chip consisting of PET-1 containing 10 wt% silica (particle size 0.3 $\mu$m) were mixed in a mixer such that the final quantity of contained silica was 0.1 wt%. Subsequently, vacuum drying was conducted at a temperature of 180 °C and a vacuum degree of 0.5 mmHg for 2 hr. Subsequently, the mixture was inserted into a 90 mm melt extruder, melted, and then extruded. The extrusion temperature was 270 °C to 290 °C. Subsequently, the mixture was cast onto a cooling drum kept at 25 °C by electrostatic adhesion. The thickness of the obtained sheet was 1 mm. In the length-wise drawing of this sheet, the sheet was drawn by a factor of 3.0 in the length-wise direction at a temperature of 90 °C. Next the sheet was drawn by a factor of 3.0 in the width-wise direction at a temperature of 95 °C on a tenter. Furthermore, heat treatment at a temperature of 220 °C was then conducted on the same tenter, and a 5 % relaxation in the width-wise direction was conducted. While passing the PET film obtained in this way through the dryer of a roll conveyer type coater and moderately reducing the tension thereof, off-line annealing treatment was conducted for 5 min at a temperature of 170 °C.

The thickness of the film obtained in this way was 100 $\mu$m, and this film is hereinafter referred to as PET-BO-1. The intrinsic viscosity [η] of the PET-BO-1 obtained in this way was 0.71, and its total light transmittance was 90 %. In addition, the water vapor permeability of this film was 7.2 g/m$^2$/24 hr/0.1 mm.

(3) Fabrication of encapsulation film A

A corona discharge of 6000 J/m$^2$ was performed on one side of the PET-BO-1 obtained as above. Meanwhile, an another PET-BO film of thickness 12 $\mu$m ("Lumirror" P11, mfg. by Toray Industries) was prepared, and upon one side of this film was formed a layer of aluminum oxide of thickness 600 Å using the spattering method.

Upon the spattered side of this spattered film, a two-coat urethane adhesive ("Adcoat" 76P1, mfg. by Toyo-Morton Ltd.) was applied, and this film was laminated to the corona-treated side of the PET-BO-1. The adhesive herein was mixed in a proportion of 1 part by mass hardener for every 100 parts by mass primary agent, and adjusted to form a 20 mass% solution in ethyl acetate. The gravure roll method was used as the coating method, and the coat thickness was adjusted to be 3 $\mu$m. The drying temperature was 100 °C. Lamination was conducted using the heated press roll method at a temperature of 60 °C and a pressure of 1 kg/cm (linear pressure). The adhesive was furthermore hardened at 60 °C for 3 days. The obtained encapsulation film A is taken to be encapsulation film FA-1. The total light transmittance of this encapsulation film FA-1 was 88 %. In addition, its water vapor permeability (non-aged product) was 0.3 g/m$^2$/24 hr/0.1 mm.

Example 2

Off-line annealing treatment was conducted on the PET-1 of example 1, in the conditions of annealing treatment being a temperature of 150 °C and a time of 3 min. Other conditions used those of example 1, and the melt discharge quantity of polymer was adjusted to yield a film of thickness 100$\mu$ m. The film obtained in this way will be hereinafter referred to as PET-BO-2. This film was then used to create an encapsulation film A, using the same methods and conditions as those of example 1. The encapsulation film A obtained in this way is taken to be encapsulation film FA-2. The intrinsic viscosity and total light transmittance of the PET-BO-2, as well as the total light transmittance of the encapsulation film FA-2, were the same values as those of the PET-BO-1 and the encapsulation film FA-1 of example 1.

Example 3

Using the method of example 1, a film was drawn by a factor of 3.5 in the length-wise direction, then drawn by a factor of 3.5 in the width-wise direction, heat-treated at a temperature of 220 °C, and then relaxed 5 % in the width-wise direction. In addition, off-line annealing treatment was performed under the same conditions as those of example 2, and the melt discharge quantity of polymer was adjusted to yield a film of thickness 100 $\mu$m. The film obtained in this way will be hereinafter referred to as PET-BO-3. This film was then used to create an encapsulation film A, using the same methods and conditions as those of example 1. The encapsulation film A obtained in this way is taken to be encapsulation film FA-3. The intrinsic viscosity and total light transmittance of the PET-BO-3, as well as the total light transmittance and water vapor permeability (non-aged product) of the encapsulation film FA-3, were the same values as those of the PET-BO-1 and the encapsulation film FA-1 of example 1.

Example 4

Using the method of example 1, a film was drawn by a factor of 3.5 in the length-wise direction, then drawn by a factor of 3.5 in the width-wise direction, heat-treated at a temperature of 210 °C, and then relaxed 3 % in the width-wise direction. In addition, off-line annealing treatment was performed, in the conditions of annealing treatment being a temperature of 140 °C and a time of 3 min. The melt discharge quantity of polymer was adjusted to yield a film of thickness 100 μm.

The film obtained in this way will be hereinafter referred to as PET-BO-4. This film was then used to create an encapsulation film A, using the same methods and conditions as those of example 1. The encapsulation film A obtained in this way is taken to be encapsulation film FA-4. The intrinsic viscosity and total light transmittance of the PET-BO-4, as well as the total light transmittance and water vapor permeability (non-aged product) of the encapsulation film FA-4, were the same values as those of the PET-BO-1 and the encapsulation film FA-1 of example 1.

Comparative example 1

Using the method of example 1, a film was drawn by a factor of 3.5 in the length-wise direction, then drawn by a factor of 3.5 in the width-wise direction, and heat-treated at a temperature of 200 °C. Relaxation and post-relaxation treatment in the width-wise direction were not performed.

The film obtained in this way will be hereinafter referred to as PET-BO-5. This film's thickness was also adjusted, using the method of example 4, to be 100 μm. This film was then used to create an encapsulation film A, using the same methods and conditions as those of example 1. The encapsulation film A obtained in this way is taken to be encapsulation film FA-5. The intrinsic viscosity and total light transmittance of the PET-BO-5, as well as the total light transmittance and water vapor permeability (non-aged product) of the encapsulation film FA-5, were the same values as those of the PET-BO-1 and the encapsulation film FA-1 of example 1.

Example 5

A membrane was fabricated using the methods and conditions of example 1. This membrane was then drawn by a factor of 3.0 in the length-wise direction, drawn by a factor of 2.6 in the width-wise direction, heat-treated at a temperature of 220 °C, and relaxed 7 % in the width-wise direction. Conditions of example 1 were used for the conditions of off-line annealing treatment, thereby obtaining a film adjusted to be thickness of 100 μm.

The film obtained in this way will be hereinafter referred to as PET-BO-6. This film was then used to create an encapsulation film A, using the same methods and conditions of those of example 1.

The encapsulation film A obtained in this way will be hereinafter referred to as encapsulation film FA-6. Although the intrinsic viscosity of this PET-BO-6 was identical to that of the PET-BO-1 of example 1, its total light transmittance was 88 %. In addition, the encapsulation film FA-6 had a total light transmittance of 86 %, and water vapor permeability (non-aged product) identical to that of the encapsulation film FA-1.

Comparative example 2

A membrane was fabricated using the methods of example 5. This membrane was then drawn by a factor of 3.6 in the length-wise direction and relaxed 14 % in the width-wise direction. Using otherwise identical conditions to those of example 5, a film of thickness 100 μm was obtained. The film obtained in this way will be hereinafter referred to as PET-BO-7. This film was then used to create an encapsulation film A, using the same methods and conditions of those of example 1. The encapsulation film A obtained in this way is taken to be encapsulation film FA-7.

The PET-BO-7 had a total light transmittance of 86 %, and its intrinsic viscosity was identical to that of the PET-BO-1. In addition, the encapsulation film FA-7 had a total light transmittance of 85 % and water vapor permeability (non-aged product) identical to that of the encapsulation film FA-1.

Example 6

A membrane was fabricated using the methods and conditions of example 1. This membrane was then drawn by a factor of 3.8 in the length-wise direction, drawn by a factor of 2.6 in the width-wise direction, heat-treated at a temperature of 210 °C, and relaxed 7 % in the width-wise direction. Off-line annealing treatment used the method of example 1, the conditions being a temperature of 140 °C and a time of 3 min. A film of thickness 100 μm was thus obtained.

The film obtained in this way will be hereinafter referred to as PET-BO-8. This film was used to obtain an encapsulation film A using the same methods and conditions of example 1. The film obtained in this way is taken to be encapsulation film FA-8.

Although the intrinsic viscosity of this PET-BO-8 was identical to that of the PET-BO-1, its total light transmittance was 92 %. The encapsulation film FA-8 had a total light transmittance of 90 % and water vapor permeability (non-aged product) identical to that of the encapsulation film FA-1.

Comparative example 3

Using the methods and conditions of example 1, a membrane was drawn by a factor of 3.8 in the length-wise direction and drawn by a factor of 2.4 in the width-wise direction. Heat treatment was conducted at a temperature of 210 °C and a 10 % relaxation in the width-wise direction was performed. Off-line annealing treatment was furthermore performed under the same conditions as those of example of 6, thereby obtaining a film of thickness 100 $\mu$m. The film obtained in this way will be hereinafter referred to as PET-BO-9. This film had a total light transmittance of 89 % and an intrinsic viscosity identical to that of the PET-BO-1. This film was furthermore used to create an encapsulation film A, using the same methods and conditions as those of example 1. This film will be referred to as encapsulation film FA-9. This encapsulation film FA-9 had a total light transmittance of 88 % and water vapor permeability (non-aged product) identical to that of the encapsulation film FA-1.

Example 7

(1) Fabrication of PEN polymer

100 parts by mass dimethyl-2, 6-naphthalene, 60 parts by mass ethylene glycol, and 0.09 parts by mass magnesium acetate tetrahydrate were placed in a reactor and gradually heated to 230 °C over 4 hr. At this point, generated methanol was removed by distillation and the transesterification were completed. To this reactant were added 0.04 parts by mass trimethyl phosphate, 0.03 parts by mass antimony trioxide, as well as 0.03 parts by mass silica particles (particle size 0.2 $\mu$m) dispersed into 10 parts by mass ethylene glycol. Polymerization of this mixture according to the common procedure was then conducted, thereby obtaining chips having an intrinsic viscosity of 0.67.

(2) Fabrication of biaxially-oriented PEN film (PEN-BO) and encapsulation film A

The chips obtained as above were vacuum dried for 2 hr at a temperature of 180 °C and a vacuum degree of 0.5 mmHg. Subsequently, the chips were inserted into a 90 mm melt extruder, melted, and extruded. The extrusion temperature was 290 °C to 310 °C. Subsequently, the extruded polymer was cast by electrostatic adhesion onto a cooling drum kept at 25 °C. The thickness of the obtained sheet was 1 mm. In the length-wise drawing of this sheet, the sheet was drawn by a factor of 3.5 in the length-wise direction at a temperature of 140 °C. Next, the sheet was drawn by a factor of 3.5 in the width-wise direction at a temperature of 135 °C on a tenter. Furthermore, heat treatment at a temperature of 250 °C under tension was then conducted on the same tenter for 5 sec, and then a 5 % relaxation in the width-wise direction was conducted, thereby obtaining a film of thickness 100 $\mu$m. This film was then subject to off-line annealing treatment for 3 min at the temperature of 160 °C, using the method of example 1.

The total light transmittance of the obtained film was 93 %. This film will be hereinafter referred to as PEN-BO-1. This film was used to create an encapsulation film A, using the methods and conditions of example 1. The obtained encapsulation film A had a total light transmittance of 90 % and water vapor permeability (non-aged product) of 0.3 g/m$^2$/24 hr/0.1 mm. This film was taken to be encapsulation film FA-10.

Example 8

(1) Fabrication of PET alloy polymer

PET polymer chips having an intrinsic viscosity of 0.65, and polyetherimide resin pellets ("Ultem", mfg. by General Electric; may be hereinafter referred to as PEI) were dried for 6 hr at a temperature of 180 °C and a vacuum degree of 0.5 mmHg. Subsequently, the PET/PEI mixture was adjusted to have a mass ratio of 90/10, fed into a melt extruder, and mixed thoroughly. Subsequently, the polymer was extruded into gut shapes at an extrusion temperature of 290 °C, hardened via water cooling, and cut into pellets.

(2) Fabrication of PET alloy film and encapsulation film A

The above pellets were vacuum dried for 2 hr at a temperature of 180 °C and a vacuum degree of 0.5 mmHg. Subsequently, these pellets were inserted into a 90 mm melt extruder, melted, and extruded. The extrusion temperature was 270 °C to 290 °C. Subsequently, the extruded polymer was cast by electrostatic adhesion onto a cooling drum kept at 25 °C. The thickness of the obtained sheet was 1 mm. In the length-wise drawing of this sheet, the sheet was drawn by a factor of 3.4 in the length-wise direction at a temperature of 95 °C. Next, the sheet was drawn by a factor of 3.4 in the width-wise direction at a temperature of 95 °C on a tenter. Furthermore, heat treatment at a temperature of 245 °C was then conducted on the same tenter, and then a 5 % relaxation in the width-wise direction was conducted. This film was then subject to off-line annealing treatment, using the conditions of example 1.

The obtained film had a thickness of 100 $\mu$m and a total light transmittance of 90 %. The film obtained in this way will be hereinafter referred to as alloy PET-BO-1. This film was then used to create an encapsulation film A, using the methods and conditions of example 1. This encapsulation film A had a total light transmittance of 88 % and water vapor permeability (non-aged product) identical to that of the encapsulation film FA-1. This encapsulation film A is taken to be encapsulation film FA-11.

Example 9

A 25 $\mu$m thick, fluorine-based film FEP (copolymer of tetrafluoroethylene and hexafluoropropylene; "Toyoflon" 25F, mfg. by Toray Industries) was prepared. A 5 kV reduced pressure plasma treatment in argon atmosphere was then performed on the surface of this film. Meanwhile, a two-coat urethane adhesive ("Adcoat" 76P1, mfg. by Toyo-Morton) was applied to the surface (on the side of the membrane layer of metal or other materials) of the encapsulation film FA-1 fabricated in example 1, the application using the conditions of example 1. This coated surface and the plasma-treated surface of the FEP were then joined and laminated. The thickness of the adhesive layer was 10 $\mu$m (dry), and lamination was conducted using the roll press method at a temperature of 80 °C and a pressure of 1 kg/cm (linear pressure). The adhesive in this laminated product was furthermore hardened at 60 °C for 3 days.

The encapsulation film B obtained in this way had a total light transmittance of 87 % and water vapor permeability (non-aged product) of 0.3 g/m$^2$/24 hr/0.1 mm. This encapsulation film B will be referred to as encapsulation film FB-1.

Example 10

15 mass% titanium oxide (particle size 0.3 $\mu$m) was added to the PET polymer of example 1. This mixture was then melt extruded using the method of example 1 to obtain an unstretched sheet of thickness 1 mm. Extrusion conditions were identical to those of example 1. This unstretched sheet was then drawn, heat-treated, relaxed in the width direction, and post-annealed treatment using the conditions of example 1, thereby obtaining a white PET-BO of thickness 100 $\mu$m.

The film obtained in this way will be hereinafter referred to as PET-BO-10. Subsequently, this film was used to create an encapsulation film A (encapsulation film FA-12), using the same method as that of example 1. The water vapor permeability (non-aged product) was the same as that of the encapsulation film FA-1.

Examples 11-18, comparative examples 4-6

Using the encapsulation films obtained in the above-described examples 1-8, as well as the encapsulation films obtained in the above-described comparative examples 1-3, the following 11 types of photovoltaic modules were produced.

For the front sheet layer, 4 mm thick flat glass (float glass, mfg. by Asahi Glass Co.), commonly referred to as white-backed glass, was prepared.

For each of the above-described encapsulation films, the following were thermocompressed using a vacuum lamination method to the side of the film having the membrane layer of metal or other materials (the imparted layer having gas barrier performance): a 400 $\mu$m thick EVA sheet, photovoltaic elements (thin film PIN junction solar elements), a 400 $\mu$m thick EVA sheet, and a glass plate, with an electrical lead wire bonded thereto. The lamination temperature was 135 °C. The relationship between the 11 types of photovoltaic modules obtained in this way and the encapsulation films used therein is shown in Table 1.

Table 1

|  | Encapsulation Film No. Used | Photovoltaic Module No. |
|---|---|---|
| Example 11 | Encapsulation film FA-1 | Photovoltaic module 1 |
| Example 12 | Encapsulation film FA-2 | Photovoltaic module 2 |
| Example 13 | Encapsulation film FA-3 | Photovoltaic module 3 |
| Example 14 | Encapsulation film FA-4 | Photovoltaic module 4 |
| Comparative Example 4 | Encapsulation film FA-5 | Photovoltaic module 5 |
| Example 15 | Encapsulation film FA-6 | Photovoltaic module 6 |
| Comparative Example 5 | Encapsulation film FA-7 | Photovoltaic module 7 |
| Example 16 | Encapsulation film FA-9 | Photovoltaic module 8 |
| Comparative Example 6 | Encapsulation film FA-10 | Photovoltaic module 9 |
| Example 17 | Encapsulation film FA-11 | Photovoltaic module 10 |
| Example 18 | Encapsulation film FA-12 | Photovoltaic module 11 |

Example 19

Using similar methods and conditions to that of examples 1-19, a photovoltaic module was created, having a configuration wherein the following are laminated to the PET film side of the encapsulation film FB-1 (i.e., the encapsulation film B of example 9): a 400 $\mu$m thick EVA sheet, photovoltaic elements (thin film PIN junction solar elements), a 400 $\mu$m thick EVA sheet, and the encapsulation film FA-1 (the membrane layer of metal or other materials facing the EVA side).

Example 20

Using the encapsulation film A of embodiment 10 (the encapsulation film FA-12), a photovoltaic module was created using the same configuration and methods as those of examples 11-18. The obtained photovoltaic module is taken to be photovoltaic module 13.

Example 21

(1) Preparation of biaxially-oriented PET film

A 6000 J/m$^2$ corona discharge was performed on both sides of the PET-BO-1 of example 1.

(2) Preparation of weather-resistant resin: benzotriazole monomer copolymerized acrylic resin

A coating agent (PUVA-30M, mfg. by Otsuka Chemical Co., Ltd.) was prepared, the agent mixed with butyl acetate so as to yield a 30 % solid concentration of the copolymer of 2-(2'-hydroxy-5'-methacryloxyethylphenyl)-2H-benzotriazole and methyl methacrylate (30 mass% and 70 mass%, respectively) therein.

(3) Fabrication of encapsulation film B

The coating in (2) above was applied in the gravure coat method to one side of the above PET-BO-1 that was subjected on both sides to corona discharge, the applied coat being adjusted so that the thickness after drying would be 5 $\mu$m. A laminated film was thus obtained.
Drying was conducted at a temperature of 120 °C for 2 min. Subsequently, an aluminum oxide film formed by spattering was laminated using the methods of example 1 to the side of the laminated film not provided with a weather-resistant resin layer, thereby obtaining an encapsulation film B. This encapsulation film had a total light transmittance of 87 % and water vapor permeability (non-aged product) of 0.3 g/m$^2$/24 hr/0.1 mm. This encapsulation film B is taken to be encapsulation film FB-2.

Example 22

The encapsulation film B obtained in example 21 (encapsulation film FB-2) was used to create a photovoltaic module, using the same configuration (such that sunlight is incident on the side having the weather-resistant resin coat) and method as those of examples 11-18. This photovoltaic module is taken to be photovoltaic module 14.

Tables 2 and 3 indicate the various evaluation results for the encapsulation films for a photovoltaic module and the photovoltaic modules using these encapsulation films for each example and comparative example. The tables list the results of the evaluations of gas barrier performance (post-aging), hydrolysis-resistance, weather-resistance, and the overall evaluations.

Table 2

| | Thermal Shrinkage Ratio (%) | | Thermal Shrinkage Ratio Balance | Post-aging Water vapor permeability (g/m$^2$/24hr/ 0.1mm) | Hydrolysis Resistance (%) | Weather Resistance (%) | Overall Evaluation | Encapsulation Film No. |
|---|---|---|---|---|---|---|---|---|
| | MD | TD | | | | | | |
| Example 1 | 0.56 | 0.10 | 0.46 | 0.5 (A) | 60 (A) | 45 (A) | A | FA-1 |
| Example 2 | 1.25 | 0.62 | 0.63 | 1.0 (A) | 62 (A) | 48 (A) | A | FA-2 |
| Example 3 | 1.47 | 0.85 | 0.62 | 2.8 (A) | 64 (A) | 47 (A) | A | FA-3 |
| Example 4 | 1.81 | 1.23 | 0.58 | 5.1 (B) | 64 (A) | 47 (A) | B | FA-4 |
| Comp. Ex. 1 | 2.13 | 1.54 | 0.59 | 6.8 (C) | 65 (A) | 50 (A) | C | FA-5 |
| Example 5 | 0.35 | - 0.93 | 1.28 | 3.2 (A) | 60 (A) | 45 (A) | A | FA-6 |
| Comp. Ex. 2 | 0.51 | - 1.52 | 2.03 | 6.7 (C) | 60 (A) | 47 (A) | C | FA-7 |
| Example 6 | 1.82 | 0.22 | 1.60 | 5.6 (B) | 65 (A) | 50 (A) | B | FA-8 |
| Comp. Ex. 3 | 1.95 | -0.11 | 2.06 | 7.0 (C) | 65 (A) | 50 (A) | C | FA-9 |
| Example 7 | 0.25 | -0.05 | 0.30 | 0.4 (A) | 75 (A) | 60 (A) | A | FA-10 |
| Example 8 | 0.22 | 0.03 | 0.19 | 0.5 (A) | 72 (A) | 60 (A) | A | FA-11 |
| Example 9 | 0.56 | 0.10 | 0.46 | 0.5 (A) | 88 (A) | 90 (A) | A | FB-1 |
| Example 10 | 0.62 | 0.18 | 0.44 | 0.5 (A) | 64 (A) | 70 (A) | A | FA-12 |
| Example 21 | 0.56 | 0.10 | 0.46 | 0.5 (A) | 68 (A) | 86 (A) | A | FB-2 |

Table 3

|  | Photovoltaic Module Output Reduction Ratio (%) | Assessment | Encapsulation Film Used | Photovoltaic Module No. |
|---|---|---|---|---|
| Example 11 | 2 | Acceptable | FA-1 | Module 1 |
| Example 12 | 4 | Acceptable | FA-2 | Module 2 |
| Example 13 | 7 | Acceptable | FA-3 | Module 3 |
| Example 14 | 9 | Acceptable | FA-4 | Module 4 |
| Comp. Ex. 4 | 14 | Unacceptable | FA-5 | Module 5 |
| Example 15 | 5 | Acceptable | FA-6 | Module 6 |
| Comp. Ex. 5 | 15 | Unacceptable | FA-7 | Module 7 |
| Example 16 | 9 | Acceptable | FA-8 | Module 8 |
| Comp. Ex. 6 | 15 | Unacceptable | FA-9 | Module 9 |
| Example 17 | 2 | Acceptable | FA-10 | Module 10 |
| Example 18 | 2 | Acceptable | FA-11 | Module 11 |
| Example 19 | 2 | Acceptable | FB-1 FA-1 | Module 12 |
| Example 20 | 3 | Acceptable | FA-12 | Module 13 |
| Example 22 | 2 | Acceptable | FB-2 | Module 14 |

Hereinafter, the results shown in Table 2 and Table 3 will be described. The encapsulation film for a photovoltaic module of the present invention uses a polyester film layer whose thermal shrinkage ratio and balance of thermal shrinkage ratios in the length-wise and width-wise directions are within a specific range. In so doing, the degradation of gas-barrier property over long-term use, which has been a problem in the conventional art, is curtailed, resulting in an inexpensive film that has excellent long-term reliability as well as excellent hydrolysis-resistance and weather-resistance.

The photovoltaic module using the encapsulation film of the present invention is improved with respect to the reduction in output over time, being an expected object of the invention. In addition, since the invention is strong against deterioration due to hydrolysis and ultraviolet rays, and since the properties of transparency, lightness of weight, and mechanical strength can be imparted thereto, the usefulness of the invention is apparent.

More specifically, the thermal shrinkage ratio at 150 °C of the PET-BO constituting the encapsulation film in examples 1-4 and comparative example 1 has been modified (the thermal shrinkage ratios in the length-wise and width-wise directions have been balanced to an almost identical value). When the thermal shrinkage ratio becomes large, there is a tendency for the gas-barrier property (i.e., the water vapor permeability) to degrade. When the thermal shrinkage ratio in either the length-wise or width-wise direction exceeds 2 %, such as in the encapsulation film of comparative example 1, it is apparent that the gas-barrier property is significantly degraded.

The four types of encapsulation films in examples 5 and 6 and comparative examples 2 and 3 have been evaluated based on the relationship between changes in the balance of the shrinkage ratios in the length-wise and width-wise directions at 150 °C and gas-barrier property. As the difference between the thermal shrinkage ratios in the length-wise and width-wise directions increases, the gas-barrier property tends to degrade. When the difference between the thermal shrinkage ratios in the length-wise and width-wise directions exceeds 2 %, it is apparent that the gas-barrier property is significantly degraded.

In addition, as shown in comparative example 3, even if these thermal shrinkage ratio values in the length-wise and width-wise directions fall within the acceptable range of the present invention, a similar tendency occurs when the difference between the thermal shrinkage ratios in the length-wise and width-wise directions exceeds 2 %, and it is apparent that the expected advantages of the invention cannot be obtained.

As in examples 11-16, if the value of the thermal shrinkage ratio for the PET-BO as a base material is controlled to be within the range specified in claim 1 of the present specification, degradation of gas-barrier property is prevented, and output reduction of the photovoltaic module can be kept within allowable limits.

However, as with comparative examples 4-6, if the thermal shrinkage ratios or the difference in the thermal shrinkage ratios in the length-wise and width-wise directions do not fall within the range specified in claim 1 of the present specification, gas-barrier property is significantly degraded, and the output reduction of the photovoltaic module cannot be kept within allowable limits. It is thought that this is due to the fact that the dimensional change of the PET-BO and the dimensional change of the EVA in the encapsulation layer differ in behavior, and because of this stress cracks develop in the hard, fragile gas barrier layer.

Ultimately, it is understood that this thermal shrinkage ratio is preferably 1.7 % or less, and most preferably 1.5 % or less. In addition, it is further preferable that the difference in the thermal shrinkage ratios in the length-wise and width-wise directions is 1.7 % or less.

In addition, it is preferable that the PET-BO constituting the encapsulation film have a high degree of polymerization compared to ordinary PET, specifically an intrinsic viscosity of 0.6 or greater. Such a value is preferable in consideration of the properties of hydrolysis-resistance and resistance to ultraviolet rays (weather-resistance).

Furthermore, as shown in examples 7, 8, 17, and 18, encapsulation films of the present invention that use PEN-BO or PET alloy film as a base material, as well as photovoltaic modules using such films, are further improved in hydrolysis-resistance and weather-resistance, and it is apparent that the expected advantages of the invention can be obtained to a higher degree.

In addition, the encapsulation film FB-1 of example 9, i.e., the encapsulation film having the configuration shown in Fig. 3 of the present specification, further improves weather-resistance and can be used to produce a photovoltaic module with a long life. A photovoltaic module as shown in Fig. 4 of the specification, wherein this encapsulation film is used for the front sheet layer and the encapsulation film FA-1 of example 1 is used for the back sheet layer, yields the advantages of the invention similarly to a conventionally-configured product using a glass plate for the front sheet layer. Moreover, such a module is lightweight compared to the conventional art.

The photovoltaic module of the present invention exhibits transparency controlled such that the total light transmittance is 80 % or greater. In so doing, the module is not only ideal as a daylighting-type module having improved electric conversion efficiency of sunlight, but is also ideal in the field of photovoltaic modules referred to as see-through types.

In addition, it is also possible, for example, to whiten the encapsulation film of the present invention by adding a substance such as titanium oxide to the PET-BO layer (example 10). As a result, not only are the expected advantages of the present invention obtainable, but improvement in the electric conversion efficiency due to the use of reflected light and designability can also be imparted (example 20).

Examples 21 and 22 indicate the characteristics of a coated and laminated encapsulation film (FB-2) having a benzotriazole monomer copolymerized acrylic resin as the weather-resistant layer, as well as a photovoltaic module using this film. In these examples it is apparent that weather-resistance is improved without degrading the characteristics of the photovoltaic module. In addition, this FB-2 is also economically favorable compared to FB-1. This encapsulation film is also ideal as a front sheet.

INDUSTRIAL APPLICABILITY

The encapsulation film for a photovoltaic module in accordance with the present invention has excellent attributes with respect to properties such as durability of gas barrier performance and hydrolysis-resistance, and is thus highly reliable.

In addition, this film is also exceptionally transparent, lightweight, and strong, and thus can be used very widely in applications as an encapsulation film for photovoltaic modules and photovoltaic modules using the same.

**Claims**

1. An encapsulation film for a photovoltaic module, comprising:

   a polyester film layer; and
   a layer composed of at least one substance selected from the group consisting of metals, metal oxides, and inorganic compounds;

   wherein the polyester film has a thermal shrinkage ratio within $(0 \pm 2)$ % at 150 °C in both length-wise and width-wise directions, and additionally, the difference between the thermal shrinkage ratios at 150 °C in the length-wise and width-wise directions is 2 % or less.

2. The encapsulation film for a photovoltaic module according to claim 1, wherein:

   the polyester film layer is a biaxially-oriented polyethylene terephthalate film having an intrinsic viscosity [η] of 0.6 to 1.2.

3. The encapsulation film for a photovoltaic module according to claim 1, wherein:

the polyester film layer is a polyimide-resin-containing, biaxially-oriented polyethylene terephthalate film.

4. The encapsulation film for a photovoltaic module according to claim 1, wherein:

the polyester film layer is a biaxially-oriented polyethylene naphthalate film.

5. The encapsulation film for a photovoltaic module according to any of claims 1-4, wherein:

the layer composed of at least one substance selected from the group consisting of metals, metal oxides, and inorganic compounds brings about gas-barrier property in the encapsulation film for a photovoltaic module; and wherein
the encapsulation film for a photovoltaic module has, as a whole, gas-barrier property such that water vapor permeability is 2.0 $g/m^2$/24 hr/0.1 mm or less.

6. The encapsulation film for a photovoltaic module according to any of claims 1-5, wherein:

the layer composed of at least one substance selected from the group consisting of metals, metal oxides, and inorganic compounds brings about gas-barrier property in the encapsulation film for a photovoltaic module; and wherein
the encapsulation film for a photovoltaic module has, as a whole, gas-barrier property such that the post-aging water vapor permeability is less than 5.0 $g/m^2$/24 hr/0.1 mm.

7. The encapsulation film for a photovoltaic module according to any of claims 1-6, wherein:

the total visible light transmittance is 80 % or greater.

8. An encapsulation film for a photovoltaic module, comprising:

the encapsulation film for a photovoltaic module according to any of claims 1-7, wherein;
a resin layer having weather-resistant properties is laminated upon at least one side of the encapsulation film.

9. The encapsulation film for a photovoltaic module according to claim 8, wherein:

the resin layer having weather-resistant properties is at least one sheet selected from the group consisting of a sheet composed of a fluororesin, a sheet composed of a polycarbonate resin, and a sheet composed of an acrylic resin.

10. The encapsulation film for a photovoltaic module according to claim 9, wherein:

the acrylic resin is a benzotriazole monomer copolymerized acrylic resin.

11. A photovoltaic module, comprising:

the encapsulation film for a photovoltaic module according to any of claims 1-10, the film being provided on the surface of the photovoltaic module on at least one side thereof.

12. A photovoltaic module, comprising:

the encapsulation film for a photovoltaic module according to any of claims 1-7, the film being provided on the surface of the photovoltaic module on one side thereof and
the encapsulation film for a photovoltaic module according to any of claims 8-10, the film being provided on the surface of the photovoltaic module on another side thereof.

Ｆｉｇ．1

Ｆｉｇ．2

Fig. 3

5
41
42

Fig. 4

5
41
42
2
3
41
42

**INTERNATIONAL SEARCH REPORT**

| International application No. |
| --- |
| PCT/JP2006/318529 |

| A. CLASSIFICATION OF SUBJECT MATTER |
| --- |
| *H01L31/042*(2006.01)i, *B32B27/36*(2006.01)i |

According to International Patent Classification (IPC) or to both national classification and IPC

**B. FIELDS SEARCHED**

Minimum documentation searched (classification system followed by classification symbols)
H01L31/04-31/078, B32B1/00-35/00

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y | JP 2005-11923 A1 (Toppan Printing Co., Ltd.),<br>13 January, 2005 (13.01.05),<br>Par. Nos. [0016] to [0027]<br>(Family: none) | 1,2,4,11<br>3,5-10,12 |
| Y | JP 2000-296594 A (Toray Industries, Inc.),<br>24 October, 2000 (24.10.00),<br>Full text; all drawings<br>(Family: none) | 3 |
| Y | JP 9-123338 A (Toray Industries, Inc.),<br>13 May, 1997 (13.05.97),<br>Par. No. [0053]<br>(Family: none) | 5,6 |

| ☒ Further documents are listed in the continuation of Box C. | ☐ See patent family annex. |
| --- | --- |

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>20 December, 2006 (20.12.06) | Date of mailing of the international search report<br>09 January, 2007 (09.01.07) |
| --- | --- |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2006/318529 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 9-48095 A  (Toray Industries, Inc.),<br>18 February, 1997 (18.02.97),<br>Full text; all drawings<br>(Family: none) | 8-10 |
| Y | JP 2000-294813 A  (Bridgestone Corp.),<br>20 October, 2000 (20.10.00),<br>Par. Nos. [0018] to [0028]<br>& US 6407329 B1          & EP 1182710 A1<br>& WO 00/62348 A1          & DE 69932098 D | 7,12 |

Form PCT/ISA/210 (continuation of second sheet) (April 2005)

**EP 1 930 953 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2000114564 A
- JP 2000138387 A
- JP 2002100788 A
- JP 2002026354 A
- JP 2000164907 A
- JP 2001244587 A
- JP H948095 B
- JP S5422234 B